(19) **Europäisches Patentamt / European Patent Office / Office européen des brevets**

(11) **EP 1 806 842 B1**

(12) **FASCICULE DE BREVET EUROPEEN**

(45) Date de publication et mention
de la délivrance du brevet:
**02.09.2009 Bulletin 2009/36**

(51) Int Cl.:
*H03H 11/04* *(2006.01)* *H03H 11/12* *(2006.01)*
*H03H 17/02* *(2006.01)*

(21) Numéro de dépôt: **06292022.8**

(22) Date de dépôt: **22.12.2006**

(54) **Circuit de filtrage à transconductance, en particulier pour un téléphone cellulaire**

Schaltkreis eines Transkonduktanzfilters, insbesondere für ein Mobiltelefon

Transconductance filter circuit, in particular for a mobile phone

(84) Etats contractants désignés:
**DE FR GB IT**

(30) Priorité: **30.12.2005 FR 0513488**

(43) Date de publication de la demande:
**11.07.2007 Bulletin 2007/28**

(73) Titulaires:
• **STMicroelectronics SA**
  **92120 Montrouge (FR)**
• **CENTRE NATIONAL DE**
  **LA RECHERCHE SCIENTIFIQUE (CNRS)**
  **75016 Paris (FR)**

(72) Inventeurs:
• **Chamla, David**
  **38000 Grenoble (FR)**
• **Cathelin, Andreia**
  **38190 Laval (FR)**
• **Kaiser, Andreas**
  **59650 Villeneuve d'Ascq (FR)**

(74) Mandataire: **Zapalowicz, Francis**
**Bureau Casalonga & Josse**
**Bayerstrasse 71/73**
**80335 München (DE)**

(56) Documents cités:
**US-A1- 2001 020 865     US-A1- 2001 048 342**
**US-A1- 2005 153 664**

## Description

L'invention concerne les circuits de filtrage, en particulier ceux incorporant des amplificateurs à transconductance.

L'invention est avantageusement mais non limitativement utilisée pour des applications liées à la téléphonie cellulaire.

Un téléphone cellulaire peut être configuré pour fonctionner selon différentes normes de transmission, telles que la norme GSM (« Global System for Mobile telecommunication », en langue anglaise), ou encore la norme UMTS (« Universal Mobile Telecommunication System », en langue anglaise).

Classiquement un téléphone cellulaire comprend dans sa chaîne d'émission et/ou de réception des signaux, un filtre, par exemple un filtre anti-repliement et de sélection de canal de type passe-bas, adapté pour une norme précise.

Ce filtre est choisi parmi un ensemble de plusieurs filtres de topologie et/ou d'ordre différents, implantés dans la chaîne d'émission et/ou de réception.

En effet, les critères exigés, comme par exemple la largeur la bande passante ou encore l'ondulation dans celle-ci, sont variables selon le type de norme de transmission en vigueur. Des topologies et/ou des ordres de filtres adaptés permettent d'atteindre les performances requises. Par conséquent, selon la norme de transmission détectée par le téléphone cellulaire ou choisie par l'utilisateur, l'un des filtres est connecté à la chaîne d'émission et/ou de réception, de façon à réaliser un filtrage optimal.

Classiquement, les filtres réalisés à partir des amplificateurs à transconductance sont particulièrement adaptés pour la réalisation des différents filtres précités, en particulier de type de Butterworth, de Tchebychev ou encore elliptique, comme décrit dans l'article Geiger, R.L. and Sanchez-Sinencio, Edgar, « Active Filter Design Using Operational Transconductance Amplifiers : A Tutorial », « IEEE Circuits and Devices Magazine, Vol. 1, Number2, pp. 20-32, March, 1985, voir aussi US 2001/0048342.

Jusqu'à présent, il était nécessaire de prévoir pour chaque téléphone cellulaire, l'ensemble des filtres nécessaires pour chaque norme considérée, et de sélectionner l'un ou l'autre de ces filtres en fonction de la norme de communication effectivement détectée.

Cette solution est par conséquent particulièrement coûteuse en termes de consommation et de surface de silicium.

L'invention vise à apporter une solution à ce problème.

Un but de l'invention est de proposer un dispositif de filtrage à architecture flexible, c'est-à-dire pouvant en particulier à partir d'une même structure, présenter sélectivement une topologie et/ou un ordre différent.

Un autre but de l'invention est de proposer un dispositif de filtrage adapté à différentes normes de transmission tout en limitant la surface de silicium pour sa réalisation ainsi que la consommation en énergie.

Ces buts sont atteints par un circuit selon la revendication 1.

En d'autres termes, le circuit de filtrage comprend plusieurs cellules élémentaires avec la même structure. On connecte ces différentes cellules élémentaires entre elles en fonction du filtre désiré, en particulier en fonction de la topologie et/ou de l'ordre du filtre désiré.

Ainsi, il est possible à partir d'un ensemble de cellules élémentaires de réaliser différents filtres d'ordres différents, ou encore de topologies différentes, ou d'ordres et de topologies différents.

Par ailleurs, l'invention a également pour avantage de permettre de créer facilement les « zéros » de transmission, caractéristiques des fonctions de transfert de certains filtres (par exemple les filtres de Tchebychev ou les filtres elliptiques) à l'aide de condensateurs couplés parallèlement aux cellules élémentaires définies ci-dessus.

Le circuit de filtrage peut présenter une architecture de type « à entrée unique » ou unipolaire (« single ended » en langue anglaise), ou bien préférentiellement, de type différentielle.

Les moyens de filtrage comprennent en outre au moins un condensateur supplémentaire connecté en parallèle aux bornes d'au moins une cellule élémentaire, et les moyens d'interconnexion commandables sont reliés en outre audit condensateur supplémentaire.

Par exemple, à partir des différentes cellules élémentaires et des condensateurs supplémentaires, il est possible de réaliser des filtres de Butterworth, de Tchebychev ou encore des filtres elliptiques d'ordres différents.

Le condensateur supplémentaire peut être connecté en parallèle aux bornes de plusieurs cellules élémentaires connectées en série.

De façon à pouvoir adapter la valeur des condensateurs élémentaires des cellules élémentaires des moyens de filtrage, ces derniers comportent au moins deux condensateurs auxiliaires connectés respectivement à chaque borne du bloc amplificateur d'au moins une cellule, par l'intermédiaire des moyens d'interconnexion.

Par exemple, les moyens d'interconnexion comportent des interrupteurs commandables.

Selon un mode de réalisation, les moyens de filtrage peuvent former par exemple un filtre passe-bas.

Selon un mode de réalisation, le circuit tel que décrit ci-avant forme un circuit intégré.

Selon un autre aspect de l'invention, il est proposé un élément d'un système de communication apte à fonctionner selon plusieurs normes de transmission différentes, incorporant un circuit tel que défini précédemment, des moyens de traitement aptes à délivrer un signal de commande de configuration aux moyens de commande en fonction de la norme de transmission désirée, de façon à obtenir la configuration désirée des moyens de filtrage.

En d'autres termes, au lieu de réaliser pour chaque élément du système de communication l'ensemble des filtres nécessaires par rapport aux normes de communication pouvant être rencontrées, on réalise l'ensemble des filtres à l'aide du circuit de filtrage selon l'invention. Selon la norme de communication détectée, les cellules élémentaires du circuit de filtrage nécessaires à la formation du filtre adapté sont sélectionnées et connectées de façon à obtenir la configuration désirée pour les moyens de filtrage.

Par exemple, l'élément peut être un élément d'un système de communication sans fil, en particulier formant un téléphone mobile cellulaire.

D'autres avantages et caractéristiques de l'invention apparaîtront à l'examen de la description détaillée de modes de réalisation et de mise en oeuvre, nullement limitatifs, et des dessins annexés, sur lesquels :

- la figure 1 décrit schématiquement une partie d'un téléphone mobile cellulaire incorporant un mode de réalisation d'un circuit selon l'invention ;
- la figure 2 décrit un mode de réalisation d'une cellule élémentaire selon l'invention ;
- la figure 3 décrit plus particulièrement une partie d'un exemple de cellule élémentaire selon l'invention ;
- la figure 4 illustre un exemple de réalisation de deux filtres d'ordres différents à partir de cellules élémentaires ; et
- les figures 5a à 5c illustrent une réalisation d'un circuit selon l'invention, permettant de réaliser deux filtres de topologies différentes.

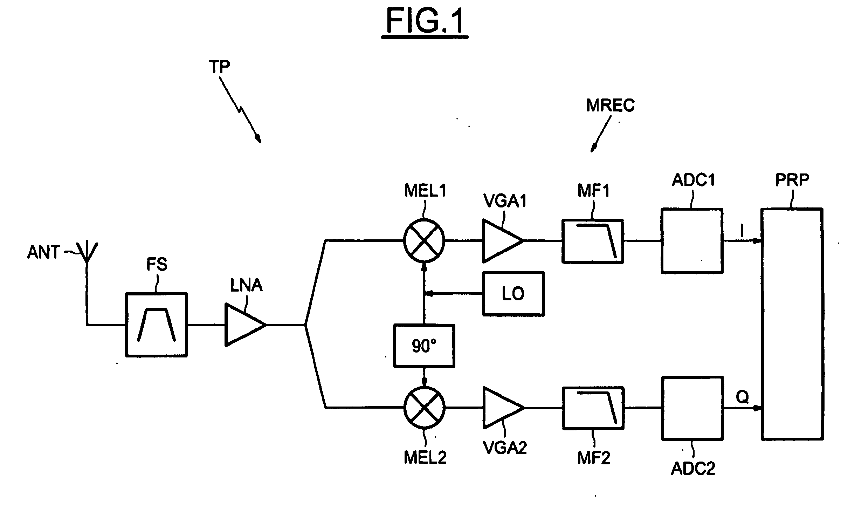

Sur la figure 1, la référence TP désigne un téléphone mobile cellulaire, dont on a représenté ici plus particulièrement la partie analogique de la chaîne de réception.

Le téléphone comprend un moyen de réception MREC connecté à une antenne ANT.

Dans cet exemple, le moyen de réception MREC est configuré pour une réception de type à conversion directe.

L'antenne est reliée à un filtre de sélection de la bande de réception FS.

Le moyen de réception MREC peut être, par exemple, ici un dispositif de syntonisation ou tuner, avantageusement entièrement réalisé de façon intégrée sur substrat de silicium. Il est par exemple de type à fréquence intermédiaire nulle, c'est-à-dire qu'il n'effectue pas de transposition de fréquence à une fréquence intermédiaire, mais ne comporte qu'un seul étage de transposition de fréquence comportant ici les mélangeurs MEL 1 et MEL 2, qui effectue une transposition directe en bande de base.

Le moyen de réception MREC comporte en tête un amplificateur faible bruit à gain variable LNA connecté entre le filtre de sélection FS et les mélangeurs MEL 1 et MEL 2.

Un oscillateur LO délivre classiquement un signal de transposition au mélangeur MEL 1, et au mélangeur MEL2 par l'intermédiaire d'un déphaseur DP de 90°.

La voix de traitement comportant le mélangeur MEL 1 est donc ici la voix de référence (voix I), tandis que la voix de traitement contenant le mélangeur MEL 2 est la voix en quadrature (voix Q).

Chaque mélangeur pour chaque voie est suivi d'un amplificateur à gain variable, respectivement VGA 1 et VGA 2, eux-mêmes suivis par deux moyens de filtrages MF1 et MF2, comprenant par exemple des filtres passe-bas, respectivement connectés aux entrées de convertisseurs analogique-numérique ADC1 et ADC2.

Les convertisseurs analogique/numérique sont connectés à un étage numérique de traitement comportant un processeur PRP, communément appelé « processeur en bande de base ».

De préférence, les filtres passe-bas sont réalisés à l'aide d'amplificateurs à transconductance avec capacités.

Les inventeurs ont observé qu'il était possible de réaliser sélectivement des filtres différents en utilisant plusieurs (au moins deux) cellules élémentaires de structure identique. La même cellule élémentaire est répétée au sein d'un même filtre et parmi les différents filtres, quel que soit leur ordre et/ou leur topologie.

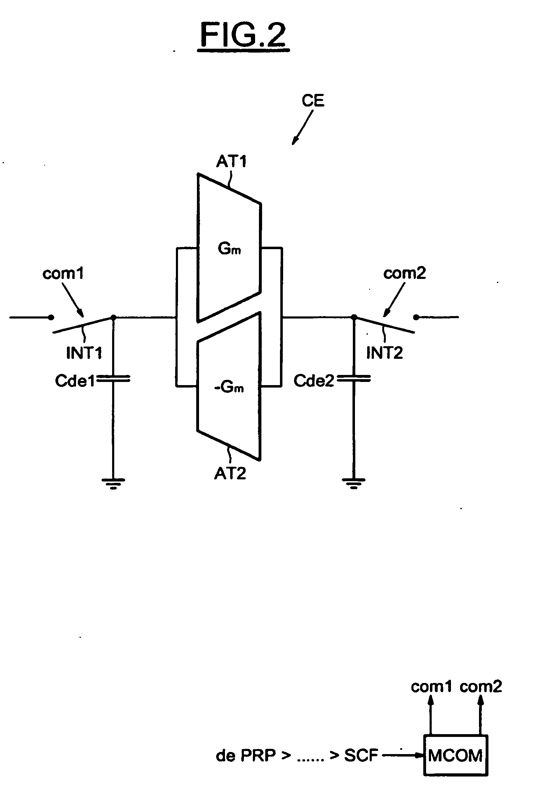

Un mode de réalisation de cette cellule élémentaire CE est représentée sur la figure 2.

Au cours de la description, les modes de réalisation décrits portent, sauf exception contraire, sur une architecture unipolaire, à des fins de simplification. Cependant, une implémentation différentielle est bien entendu possible, voire préférable pour certaines applications. L'homme du métier saura adapter à une architecture différentielle les modes de réalisation décrits ci-après.

La cellule CE comprend deux condensateurs élémentaires Cde1 et Cde2 reliés à la masse et un bloc amplificateur à transconductance BGm comprenant une structure de type gyrateur AT1 et AT2, connectée en série entre les deux condensateurs.

Cette structure de gyrateur comprend un premier amplificateur à transconductance AT1 rebouclé sur lui-même par un deuxième amplificateur à transconductance AT2, ayant une transconductance opposée à celle du premier amplificateur.

A chaque noeud d'entrée et de sortie de la cellule élémentaire CE, est connecté un interrupteur commandé respectivement INT1 et INT2.

Des moyens de commande MCOM délivre les signaux de commande com1 et com2 des interrupteurs com1 et com2.

Ces moyens de commande MCOM peuvent être réalisés classiquement par des circuits logiques.

Dans le cas d'une application en télécommunication, les moyens de commande MCOM peuvent recevoir un signal de configuration SCF émanant du processeur en bande de base PRP. Ce signal de configuration dépend de la norme de transmission utilisée.

Ainsi, il est possible de réaliser les différents filtres désirés à partir de cellules élémentaires communes et d'autres cellules élémentaires connectées selon l'ordre ou la topologie désirée par l'intermédiaire des interrupteurs com1 et com2.

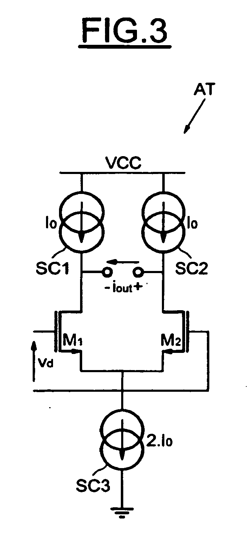

La figure 3 illustre un exemple d'amplificateur à transconductance AT utilisé au sein de la cellule élémentaire CE et réalisé avec une architecture différentielle.

L'amplificateur AT reçoit en entrée une tension différentielle $v_d$. Celle-ci est appliquée entre les deux électrodes de commande (ici les grilles) de deux transistors $M_1$ et $M_2$, de type NMOS, dans cet exemple. Chaque transistor M1 et M2 est polarisé par un courant $I_0$, délivré respectivement par les sources de courant SC1 et SC2. Les deux sources de courant SC1 et SC2 sont reliées à une borne d'alimentation délivrant la tension VCC.

Les deux électrodes de sortie des transistors $M_1$ et $M_2$, ici les sources, sont communes, et le noeud commun est connecté à une source de courant SC3 délivrant un courant de $2*I_0$. La source de courant SC3 est par ailleurs reliée par son autre borne à la masse.

Le courant de sortie $i_{out}$ délivré par l'amplificateur AT est mesuré entre les deux électrodes d'entrée (ici les drains) des transistors $M_1$ et $M_2$. Ce courant de sortie $i_{out}$ correspond à la différence entre le courant mesuré sur les électrodes d'entrée (les drains) et leurs courants de polarisation respectifs $I_0$.

Dans le cas des amplificateurs ayant une valeur de transconductance opposée, les bornes de l'entrée différentielle ou les bornes de la sortie différentielle sont inversées.

Un circuit de filtrage reconfigurable selon l'invention comprend typiquement aussi des moyens d'entrée, des moyens de sortie et des moyens de filtrage comprenant un moins deux cellules et des moyens d'interconnexion comprenant par exemple des interrupteurs.

De façon générale, les moyens d'entrée et de sortie jouent un rôle d'interface entre les moyens de filtrage et les composants extérieurs à ces moyens de filtrage et effectuent en général des conversions tension/courant et des conversions courant/tension. Ces moyens sont connus en soi.

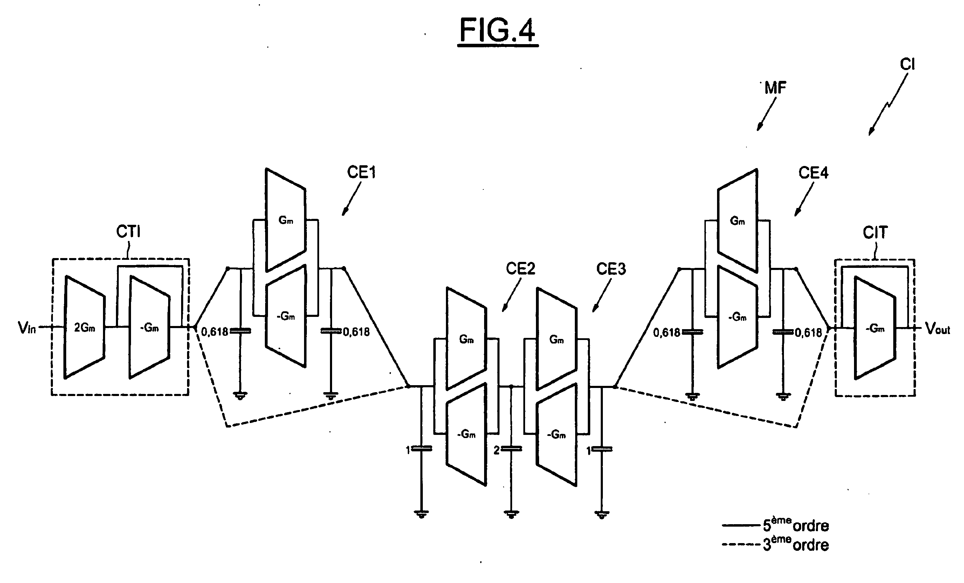

On se réfère à présent à la figure 4 qui illustre un circuit de filtrage CI selon l'invention, qui permet de réaliser deux filtres de Butterworth passe-bas du troisième ordre ou du cinquième ordre.

Le circuit CI reçoit en entrée une tension d'entrée $V_{in}$ délivrée aux moyens d'entrée, ici un convertisseur tension-courant CTI, réalisé par exemple à l'aide d'un amplificateur à transconductance avec une transconductance égale à $2G_m$ (pour compenser la perte de moitié du signal engendré par l'utilisation d'amplificateurs à transconductance par rapport à un filtre classique de type RLC en échelle) connectée en série à un autre amplificateur à transconductance ayant une transcon-

ductance égale à $-G_m$ et dont la sortie est rebouclée sur son entrée.

Le convertisseur CTI joue en outre le rôle d'interface avec les composants connectés en amont.

Les moyens de filtrage MF comprennent ici quatre cellules élémentaires, CE1, CE2, CE3 et CE4.

Les cellules élémentaires CE1 et CE4 comprennent chacune une structure de type gyrateur, telle que décrite ci-avant, et deux condensateurs ayant chacun une valeur relative égale à 0,618.

Cette valeur relative est déterminée en fonction d'une valeur capacitive de référence utilisée pour calculer la fréquence de coupure des moyens de filtrage selon

la formule : $Fc = \dfrac{g_m}{2\pi C}$ , Fc étant la fréquence de coupure.

La valeur de transconductance et la valeur de la capacité de référence sont ajustées de façon à avoir un compromis entre le bruit et la consommation acceptables.

En d'autres termes, chaque valeur attribuée aux condensateurs des moyens de filtrage, est un coefficient à multiplier par la valeur capacitive de référence.

Les cellules élémentaires CE2 et CE3 sont formées de deux structures de type gyrateur et de deux condensateurs ayant comme coefficient 1, les deux condensateurs connectés au noeud commun étant symbolisés par un unique condensateur ayant pour coefficient 2.

Les moyens de filtrage MF sont connectés aux moyens de sortie, ici convertisseur courant-tension CIT, délivrant une tension de sortie $V_{out}$.

De même que pour le convertisseur CTI, le convertisseur CIT joue le rôle d'interface avec les composants connectés en aval.

Pour réaliser le filtre de Butterworth du cinquième ordre, les interrupteurs vont être commandés pour connecter en série les quatre cellules élémentaires, CE1, CE2, CE3 et CE4.

Pour réaliser un filtre de Butterworth du troisième ordre, les interrupteurs vont permettre de connecter directement les cellules CE2 et CE3 au convertisseur tension-courant CTI et au convertisseur courant-tension CIT.

Ainsi, en réutilisant les deux cellules élémentaires CE2 et CE3 présentes pour un filtre de Butterworth au troisième ordre, et en rajoutant respectivement les cellules élémentaires CE1 et CE4 en amont et en aval, il est possible de construire un filtre de Butterworth du cinquième ordre.

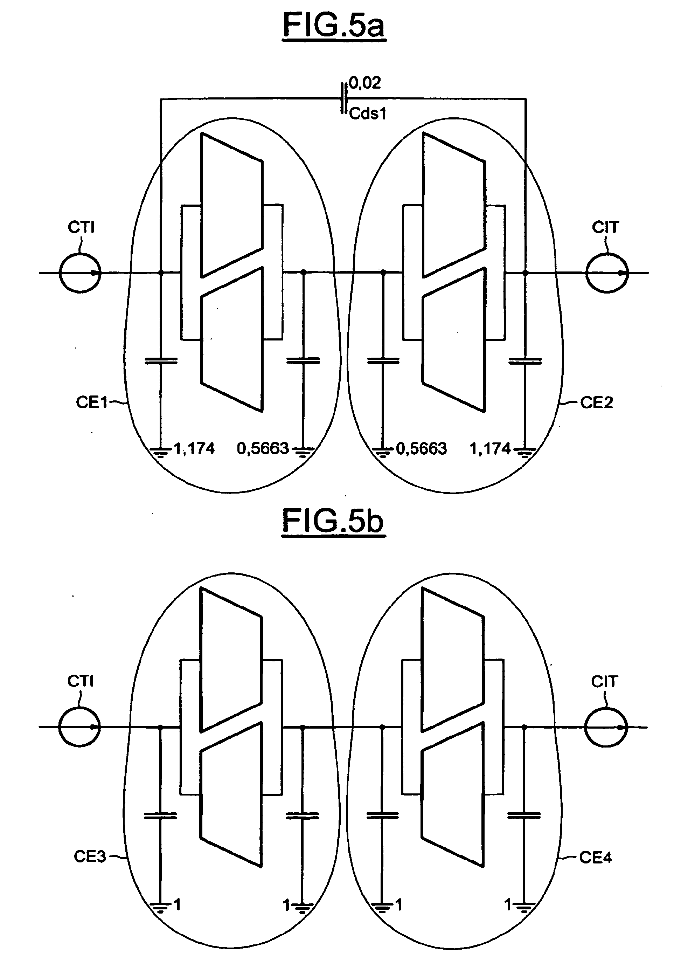

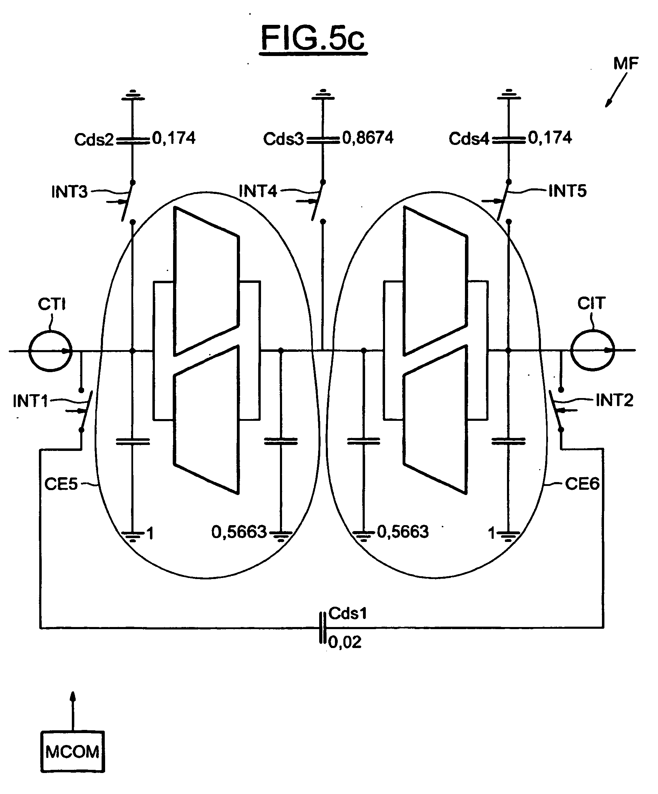

On se réfère à présent aux figures 5a, 5b et 5c.

La figure 5a représente un filtre du troisième ordre, de type elliptique.

Les moyens de filtrage MF comprennent dans cet exemple, deux cellules élémentaires CE1 et CE2 connectées en série entre un convertisseur d'entrée tension-courant CTI et un convertisseur de sortie courant-tension CIT. Les condensateurs des cellules élémentaires CE1 et CE2 ont chacun pour coefficient 1,174 et 0,5663.

En outre, le filtre comprend un condensateur supplémentaire $C_{ds1}$, avec ici comme coefficient 0,02, connecté en parallèle entre la première borne de la cellule élémentaire CE1 et la deuxième borne de la cellule élémentaire CE2.

Sur la figure 5b, est représenté un filtre de type Butterworth du troisième ordre.

Celui-ci comprend deux cellules élémentaires CE3 et CE4 connectées en série entre le convertisseur tension-courant CTI et le convertisseur courant-tension CIT.

Les condensateurs des deux cellules élémentaires CE3 et CE4 ont chacun pour valeur 1.

La figure 5c représente des moyens de filtrage MF selon l'invention, permettant de réaliser les filtres de troisième ordre elliptiques et de Butterworth illustrés sur les figures 5a et 5b.

Pour ce faire, les moyens de filtrage MF comprennent deux cellules élémentaires CE5 et CE6 connectées en série entre un convertisseur d'entrée tension-courant CTI et un convertisseur de sortie courant-tension CIT.

Les condensateurs des cellules élémentaires CE5 et CE6 ont pour coefficient 1 et 0,5663. Le condensateur supplémentaire $C_{ds1}$ est connecté en parallèle aux deux cellules élémentaires CS5 et CS6 par l'intermédiaire de deux interrupteurs INT1 et INT2, commandés par un signal délivré par les moyens de commande MCOM.

Les moyens de filtrage MF comportent également trois autres condensateurs auxiliaires, $C_{ds2}$, $C_{ds3}$ et $C_{ds4}$, ayant dans cet exemple pour coefficient respectifs 0,174 ; 0,8674 et 0,174.

Ces trois condensateurs auxiliaires, $C_{ds2}$, $C_{ds3}$ et $C_{ds4}$, sont reliés respectivement à la première borne de la cellule élémentaire CE5, à la borne commune des cellules élémentaires CE5 et CE6, et à la deuxième borne de la cellule élémentaire CE6, par l'intermédiaire de trois interrupteurs INT3, INT4, INT5. Ces interrupteurs sont commandés par un signal de commande délivré par les moyens de commande MCOM.

Lorsque les interrupteurs INT1, INT2, INT3 et INT5 sont fermés, et que l'interrupteur INT4 est en position ouverte, les moyens de filtrage MF reproduisent le filtre d'ordre 3, de type elliptique, illustré sur la figure 5a.

A l'inverse, lorsque l'interrupteur INT4 est en position fermée, et que les interrupteurs INT1, INT2, INT3 et INT5 sont en position ouverte, les moyens de filtrage MF reproduisent le filtre d'ordre 3, de type Butterworth, illustré sur la figure 5b.

En réutilisant les mêmes cellules élémentaires et en commandant leur connexion en fonction d'un paramètre extérieur, par exemple une norme de communication, il est possible de diminuer les surfaces de silicium des moyens de filtrage jusqu'à 25% pour certaines topologies de filtres.

En outre, les filtres représentés possèdent une parfaite symétrie, ce qui améliore considérablement les performances d'appariement des circuits réalisés pour certains types de filtres.

Outre l'application dans le domaine des télécommunications, l'invention est particulièrement adaptée pour les applications audio, ou toute chaîne de traitement de signal requérant un filtrage analogique.

## Revendications

1. Circuit de filtrage à transconductance comprenant des moyens d'entrée (CTI) des moyens de sortie (CIT) et des moyens de filtrage (MF) couplés entre les moyens d'entrée et les moyens de sortie, **caractérisé par le fait que** les moyens de filtrage sont configurables à l'aide d'au moins plusieurs cellules élémentaires (CE) de même structure et de moyens d'interconnexion commandables (INT1, INT2) possédant chacun un état ouvert ou fermé, et reliés aux cellules élémentaires et aux moyens d'entrée et de sortie, **par le fait que** chaque cellule élémentaire comporte deux condensateurs élémentaires (Cdel, Cde2) et un bloc amplificateur à transconductance (BGm) connecté en série entre les deux condensateurs élémentaires, ledit bloc comportant un premier amplificateur (AT1) à transconductance rebouclé sur lui-même par un deuxième amplificateur à transconductance (AT2) ayant une valeur de transconductance opposée à celle du premier amplificateur, et **par le fait que** le circuit comprend en outre des moyens de commande (MCOM) aptes à rendre ouverts ou fermés les moyens d'interconnexion en fonction de la configuration désirée des moyens de filtrage, et **par le fait que** les moyens de filtrage comprennent en outre au moins un condensateur supplémentaire (Cdsl) connecté en parallèle aux bornes d'au moins une cellule élémentaire et les moyens d'interconnexion commandables sont reliés en outre audit condensateur supplémentaire.

2. Circuit selon la revendication 1, dans lequel le condensateur supplémentaire est connecté en parallèle aux bornes de plusieurs cellules élémentaires connectées en série.

3. Circuit selon l'une des revendications précédentes, dans lequel les moyens de filtrage comportent au moins deux condensateurs auxiliaires (Cds2, Cds3, Cds4) connectés respectivement à chaque borne du bloc amplificateur d'au moins une cellule, par l'intermédiaire des moyens d'interconnexion (INT3, INT4, INT5).

4. Circuit selon l'une des revendications précédentes, dans lequel les moyens d'interconnexion comportent des interrupteurs commandables.

5. Circuit selon l'une des revendications précédentes, dans lequel les moyens de filtrage forment un filtre passe-bas.

6. Circuit selon l'une des revendications précédentes, formant un circuit intégré.

7. Elément d'un système de communication apte à fonctionner selon plusieurs normes de transmission différentes, incorporant un circuit selon l'une des revendications précédentes, des moyens de traitement aptes à délivrer un signal de commande de configuration aux moyens de commande en fonction de la norme de transmission désirée, de façon à obtenir la configuration désirée des moyens de filtrage.

8. Elément selon la revendication 7, appartenant à un système de communication sans fil, et formant en particulier un téléphone mobile cellulaire (TP).

**Claims**

1. Transconductance filtering circuit comprising input means (CTI), output means (CIT) and filtering means (MF) coupled between the input means and the output means, **characterized in that** the filtering means are configurable by means of at least two elementary cells (CE) of the same structure and of controllable interconnection means (INT1, INT2) each having an open or closed state, and being connected to the elementary cells and to the input and output means, **in that** each elementary cell comprises two elementary capacitors (Cdel, Cde2) and a transconductance amplifier unit (BGm) connected in series between the two elementary capacitors, the said unit comprising a first transconductance amplifier (AT1) fed back onto itself via a second transconductance amplifier (AT2) having a transconductance value opposite to that of the first amplifier, **in that** the circuit also comprises control means (MCOM) capable of opening or closing the interconnection means depending on the desired configuration of the filtering means, and **in that** the filtering means also comprise at least one additional capacitor (Cdsl) connected in parallel with the terminals of at least one elementary cell and the controllable interconnection means are also connected to the said additional capacitor.

2. Circuit according to Claim 1, in which the additional capacitor is connected in parallel with the terminals of several elementary cells connected in series.

3. Circuit according to either of the preceding claims, in which the filtering means comprise at least two auxiliary capacitors (Cds2, Cds3, Cds4) respectively connected to each terminal of the amplifier unit of at least one cell via the interconnection means (INT3, INT4, INT5).

4. Circuit according to one of the preceding claims, in which the interconnection means comprise controllable switches.

5. Circuit according to one of the preceding claims, in which the filtering means form a low-pass filter.

6. Circuit according to one of the preceding claims, forming an integrated circuit.

7. Element of a communications system capable of operating according to several different transmission standards, incorporating a circuit according to one of the preceding claims, processing means capable of delivering a configuration control signal by means of a command depending on the desired transmission standard, in such a manner as to obtain the desired configuration of the filtering means.

8. Element according to Claim 7, belonging to a wireless communications system, and forming in particular a cellular mobile telephone (TP).

**Patentansprüche**

1. Transkonduktanz-Filterschaltung, die Eingangseinrichtungen (CTI), Ausgangseinrichtungen (CIT) und Filtereinrichtungen (MF) enthält, welche zwischen die Eingangseinrichtungen und die Ausgangseinrichtungen geschaltet sind, **dadurch gekennzeichnet, dass** die Filtereinrichtungen mit Hilfe mindestens mehrerer Elementarzellen (CE) gleicher Struktur und steuerbarer Verbindungseinrichtungen (INT1, INT2) konfigurierbar sind, die je einen offenen oder geschlossenen Zustand besitzen, und mit den Elementarzellen und mit den Eingangs- und Ausgangseinrichtungen verbunden sind, **dadurch**, dass jede Elementarzelle zwei Elementarkondensatoren (Cde1, Cde2) und einen Transkonduktanz-Verstärkungsblock (BGm) aufweist, der zwischen den zwei Elementarkondensatoren in Reihe geschaltet ist, wobei der Block einen ersten Transkonduktanz-Verstärker (AT1) aufweist, der durch einen zweiten Transkonduktanz-Verstärker (AT2) auf sich selbst zurückgeschleift wird, welcher einen Transkonduktanzwert entgegengesetzt zu demjenigen des ersten Verstärkers hat, und **dadurch**, dass die Schaltung außerdem Steuereinrichtungen (MCOM) enthält, die die Verbindungseinrichtungen in Abhängigkeit von der gewünschten Konfiguration der Filtereinrichtungen öffnen oder schließen können, und **dadurch**, dass die Filtereinrichtungen außerdem mindestens einen zusätzlichen Kondensator (Cds1) enthalten, der mit den Klemmen mindestens einer Elementarzelle parallelgeschaltet ist, und die steuerbaren Verbindungseinrichtungen außerdem mit dem zusätzlichen Kondensator verbunden sind.

2. Schaltung nach Anspruch 1, bei der der zusätzliche Kondensator mit den Klemmen mehrerer in Reihe geschalteter Elementarzellen parallelgeschaltet ist.

3. Schaltung nach einem der vorhergehenden Ansprüche, bei der die Filtereinrichtungen mindestens zwei Hilfskondensatoren (Cds2, Cds3, Cds4) aufweisen, die mit jeder Klemme des Verstärkungsblocks mindestens einer Zelle über Verbindungseinrichtungen (INT3, INT4, INT5) verbunden sind.

4. Schaltung nach einem der vorhergehenden Ansprüche, bei der die Verbindungseinrichtungen steuerbare Schalter aufweisen.

5. Schaltung nach einem der vorhergehenden Ansprüche, bei der die Filtereinrichtungen ein Tiefpassfilter bilden.

6. Schaltung nach einem der vorhergehenden Ansprüche, die eine integrierte Schaltung bildet.

7. Element eines Kommunikationssystems, das gemäß mehreren verschiedenen Übertragungsnormen arbeiten kann, in das eine Schaltung nach einem der vorhergehenden Ansprüche und Verarbeitungseinrichtungen eingebaut sind, die ein Konfigurations-Steuersignal an die Steuereinrichtungen in Abhängigkeit von der gewünschten Übertragungsnorm liefern können, um die gewünschte Konfiguration der Filtereinrichtungen zu erhalten.

8. Element nach Anspruch 7, das zu einem drahtlosen Verbindungssystem gehört und insbesondere ein zellulares Mobiltelefon (TP) bildet.

## FIG.1

EP 1 806 842 B1

# FIG.2

CE

AT1

$G_m$

com1

com2

INT1

INT2

Cde1

Cde2

-$G_m$

AT2

com1 com2

de PRP > ...... > SCF ⟶ MCOM

# FIG.3

# FIG.4

EP 1 806 842 B1

# FIG.5a

0,02

Cds1

CTI

CIT

CE1

1,174    0,5663    0,5663    1,174

CE2

# FIG.5b

CTI

CIT

CE3

1    1    1    1

CE4

## FIG.5c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20010048342 A

**Littérature non-brevet citée dans la description**

- **Geiger, R.L. ; Sanchez-Sinencio, Edgar.** Active Filter Design Using Operational Transconductance Amplifiers : A Tutoria. *IEEE Circuits and Devices Magazine,* Mars 1985, vol. 1 (2), 20-32